# EUROPEAN PATENT APPLICATION

(11) **EP 2 509 339 A1**
(43) Date of publication of application: **10.10.2012**
(21) Application number: 10834697.4
(22) Date of filing: 11.02.2010
(51) Int. Cl.: H04R 19/04, H04R 19/00

(54) **MEMS MICROPHONE AND MANUFACTURING METHOD THEREOF**

(30) Priority: 04.12.2009 KR 20090119552
(71) Applicant: BSE Co., Ltd., Incheon 405-817 (KR)
(72) Inventor: KIM, Yong-Kook, Seoul 157-040 (KR)
(74) Representative: Mollekopf, Gerd Willi
(86) International application number: PCT/KR2010/000883
(87) International publication number: WO 2011/068282

(57) **Abstract**

The present invention relates to an MEMS microphone capable of preventing a membrane and a back plate from being contacted by an overvoltage or an external shock and the like, and a manufacturing method thereof. Further, the present invention provides an MEMS microphone and a manufacturing method thereof, comprising: a silicon substrate on which a back chamber is formed; a back plate which is deposited on the silicon substrate, and is formed with a plurality of sound holes; a membrane which is deposited on the silicon substrate in order to form an air gap by being isolated from the back plate; and a contact prevention electrode unit which applies repulsive forces to the membrane and is deposited on the silicon substrate.

## Description

### Technical Field

The present invention relates to a micro electro mechanical system (MEMS) microphone and a method of manufacturing the same.

### Background Art

Generally, a microphone is a device for converting sounds to electric signals. The microphone may be used in various mobile communication devices, such as mobile phones, and various communication devices including earphones and hearing aids. It is necessary for the microphone to have excellent electronic/sound performance, reliability, and operability.

Microphones may be classified into condenser microphones and micro electro mechanical system (MEMS) microphones.

A condenser microphone is manufactured by manufacturing each component, such as a diaphragm, a back plate, and a printed circuit board (PCB) for signal processing, and assembling the components inside a casing. The condenser microphone is manufactured via two separate processes, that is, a process for fabricating a PCB and a process for manufacturing the condenser microphone. Therefore, the costs for manufacturing the condenser microphone are high, and there are limits in miniaturizing the condenser microphone.

A MEMS microphone is manufactured by fabricating all sound detecting devices, such as a diaphragm, a back plate, etc., on a single silicon substrate via semiconductor fabrication processes.

Korean Patent Application No. 10-2002-0074492 (filed on November 27, 2002) discloses a MEMS microphone. The MEMS microphone is thermally treated at a high temperature, which is about 1100°C, to implant electrons into a bottom electrode. Since a membrane (diaphragm) is substantially formed of different materials, such as a metal bottom electrode, a silicon nitride film, and a silicon oxide film, residual stress (compressive stress or tensile stress) is formed during the thermal treatment due to different thermal expansion coefficients. Thus, the membrane may be deformed or cracked due to the residual stress applied thereto. Furthermore, when the residual stress is applied to the membrane, it may be difficult for the membrane to precisely oscillate according to sounds, and thus, it may be difficult to precisely convert sounds to electric signals.

International Patent Open Publication No. WO 2007/117343 (published on March 29, 2007) discloses a method of forming a MEMS microphone, in which a back side is formed by oxidating a silicon substrate. Here, a porous silicon structure is oxidated to form the back side in the silicon substrate, and, to form the silicon structure, operations for forming and etching a conductive layer, a metal layer, a silicon oxide layer, etc. (operations 1A through 1H) are sequentially performed. Since it is necessary to perform a plurality of operations to form the porous silicon structure, a time elapsed for manufacturing the MEMS microphone may significantly increase. Furthermore, the rate of oxidating silicon of the porous silicon structure may become nonuniform according to a voltage condition, and thus, the back side may be etched unevenly. If a surface of the back side is unevenly etched, a distance between a diaphragm and a back plate becomes uneven, and thus, it may be difficult to precisely convert sounds to electric signals.

Furthermore, in the MEMS microphone, the diaphragm and the back plate are formed of polysilicon material. The diaphragm and the back plate should be connected to a circuit for measuring a capacitance, and thus, the diaphragm and the back plate should be conductive. Therefore, the diaphragm and the back plate are heated to a high temperature, which is about 1100°C, after conductive ions are implanted into the diaphragm and the back plate.

A process for manufacturing a MEMS microphone includes a process for manufacturing a MEMS chip after a process for manufacturing an application specific integrated chip (ASIC), which is formed of a metal and has patterned thereon a circuit. Therefore, it is difficult to manufacture the MEMS chip and the ASIC as one chip. The reason is that, when the ASIC is exposed to a high temperature in a process for manufacturing the MEMS chip, the circuit patterned onto the ASIC melts or is damaged. Furthermore, since it is difficult to manufacture the MEMS chip and the ASIC as one chip, it is necessary to manufacture the MEMS chip and the ASIC via separate processes. Therefore, the number of manufacturing processes and manufacturing costs may increase.

Furthermore, according to the cited references above, the membrane and the bottom electrode may contact each other when an excessive voltage or an external shock is applied to the membrane or the bottom electrode. Therefore, there may be cases in which it is difficult to convert sounds to electric signals.

### Disclosure of the Invention

### Technical Goals

The present invention provides a micro electro mechanical system (MEMS) microphone capable of preventing a membrane and a back plate from contacting each other even if an excessive voltage or an external shock is applied to the membrane and the back plate and a method of manufacturing the MEMS microphone.

The present invention also provides an MEMS microphone in which it is not necessary to heat a membrane and a back plate to a high temperature to implant ions into the membrane and the back plate and formation of residual stress at the membrane and the back plate may be minimized and a method of manufacturing the MEMS microphone.

### Technical Solutions

According to an aspect of the present invention, there is provided an MEMS microphone including a silicon substrate in which a back chamber is to be formed; a back plate which is formed on the silicon substrate and has formed therein a plurality of sound holes; a membrane which is formed on the silicon substrate at a predetermined distance apart from the back plate to form an air gap; and a contact-preventing electrode unit which is formed on the silicon substrate and applies a repulsive force to the membrane.

The membrane and the back plate may have polarities opposite to each other, and the contact-preventing electrode unit may have the same polarity as the membrane.

According to another aspect of the present invention, there is provided a method of manufacturing a MEMS microphone, the method including forming a contact-preventing electrode unit to a silicon substrate; forming a membrane to the silicon substrate to be apart from the contact-preventing electrode unit; forming a sacrificing layer to the membrane; forming a back plate for applying a repulsive force to the contact-preventing electrode unit onto the sacrificing layer; forming a back chamber by etching the lower portion of the silicon substrate; and forming an air gap between the membrane and the back chamber by removing the sacrificing layer.

According to another aspect of the present invention, there is provided a method of manufacturing an MEMS microphone, the method including forming a contact-preventing electrode unit to a silicon substrate; forming a back plate to the silicon substrate to be apart from the contact-preventing electrode unit; forming a sacrificing layer to the back plate; forming a membrane for applying repulsive force to the contact-preventing electrode unit onto the sacrificing layer; forming a back chamber by etching the lower portion of the silicon substrate; and forming an air gap between the membrane and the back chamber by removing the sacrificing layer.

### Advantageous Effects

According to embodiments of the present invention, a contact-preventing electrode unit applies repulsive force to a membrane. Therefore, even if an excessive voltage or an external shock is applied to the membrane, the membrane and the back plate may be prevented from contacting each other.

According to embodiments of the present invention, it is not necessary to heat a membrane and a back plate to a high temperature to implant ions into the membrane and the back plate, and formation of residual stress in the membrane and the back plate may be minimized. Furthermore, formation of cracks in areas where the membrane and the back plate contact a silicon substrate may be prevented

According to embodiments of the present invention, since a membrane and a back plate are formed via electroless plating, thicknesses of the membrane and the back plate may be easily controlled. Therefore, acoustic properties may be stabilized and acoustic sensitivity may be improved.

### Brief Description of the Drawings

FIGS. 1 through 3 are sectional views showing operations for forming an air gap forming portion in a silicon substrate according to an embodiment of the present invention;
FIGS. 4 through 6 are sectional views showing operations for forming a contact-preventing electrode unit to an air gap forming portion of a silicon substrate;
FIG. 7 is a sectional view showing an operation for forming a membrane to an air gap forming portion;
FIGS. 8 and 9 are sectional views showing operations for forming a sacrificing layer and a back plate to the top surface of a membrane of a silicon substrate;
FIGS. 10 through 12 are sectional views showing operations for forming a back chamber and an air gap in a silicon substrate;
FIG. 13 is a diagram showing polarities of a membrane, a back plate, and a contact-preventing electrode;
FIG. 14 is a sectional view showing an operation for forming an air gap forming portion in a silicon substrate according to an embodiment of the present invention;
FIGS. 15 and 16 are sectional views showing operations for forming a contact-preventing electrode unit to an air gap forming portion of a silicon substrate;
FIGS. 17 through 19 are sectional views showing operations for forming a back plate to an air gap forming portion of a silicon substrate;
FIGS. 20 and 21 are sectional views showing operations for forming a sacrificing layer and a back plate to the top surface of a membrane of a silicon substrate;
FIGS. 22 and 23 are sectional views showing operations for forming a back chamber and an air gap in a silicon substrate; and
FIG. 24 is a diagram showing polarities of a membrane, a back plate, and a contact-preventing electrode.

### Best mode for carrying out the Invention

Hereinafter, the present invention will be described in detail by explaining preferred embodiments of the invention with reference to the attached drawings.

A micro electro mechanical system (MEMS) microphone according to an embodiment of the present invention will be described below.

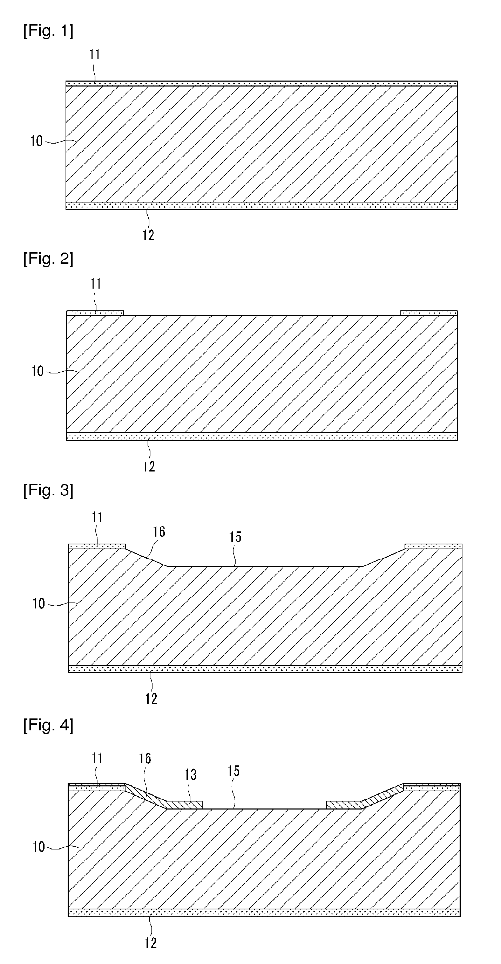

FIGS. 1 through 3 are sectional views showing operations for forming an air gap forming portion in a silicon substrate according to an embodiment of the present invention.

Referring to FIGS. 1 and 2, the MEMS microphone includes a silicon substrate 10. Insulation protection layers 11 and 12, formed of silicon nitride (Si₃N₄) or silicon oxide (SiO₂), for example, are formed on both surfaces of the silicon substrate 10 (refer to FIG. 1). Here, in the case of the silicon nitride, the insulation protection layers 11 and 12 are formed on surfaces of the silicon substrate 10 by using low pressure chemical vapor deposition (LPCVD).

The insulation protection layer 11 on the top surface of the silicon substrate 10 is etched to form an air gap forming portion 15 (refer to FIG. 2). Here, the insulation protection layer 11 on the top surface of the silicon substrate 10 may be etched by using a reactive ion etching (RIE) equipment.

Referring to FIG. 3, the air gap forming portion 15 is formed to a preset depth by etching the upper portion of the silicon substrate 10 by using a KOH solution or a TMAH solution. Here, a masking material (not shown) of the air gap forming portion 15 may be silicon oxide (SiO₂) or silicon nitride (Si₃N₄).

A distance between a membrane 25 and a back plate 37 described below may be adjusted by adjusting the depth of the air gap forming portion 15 to a preset depth. The depth of the air gap forming portion 15 may be adjusted according to concentration of the KOH solution or the TMAH solution, etching time, etching temperature, etc. It is necessary to adjust concentration of the KOH solution or the TMAH solution, etching time, etching temperature, etc. according to the desired depth of the air gap forming portion 15.

Furthermore, portions surrounding the air gap forming portion 15 may form a sloped surface 16 having an angle α, which is approximately 54.74°, as the portions are wet-etched by using the KOH solution or the TMAH solution. Here, reaction with the KOH solution or the TMAH solution is relatively slow in a direction in which silicon crystals are inclined (i.e., a direction of a surface 111), whereas reaction with the KOH solution or the TMAH solution is relatively fast in a direction perpendicular to the silicon crystals (i.e., a direction of a surface 100). Therefore, the portions surrounding the air gap forming portion 15 are etched to form the sloped surface 16.

FIGS. 4 through 6 are sectional views showing operations for forming a contact-preventing electrode unit to an air gap forming portion of a silicon substrate.

Referring to FIGS. 4 through 6, an insulation layer 13 is formed onto the air gap forming portion 15 of the silicon substrate 10. Here, the insulation layer 13 may be etched, such that a portion of the insulation layer 13 slightly extending toward the center thereof from the sloped surface 16 of the air gap forming portion 15 and end portions of the insulation layer 13 remain. Here, the center portion of the insulation layer 13 is removed via the etching.

A contact-preventing electrode unit 17 may be formed onto the insulation layer 13. Operations for forming the contact-preventing electrode unit 17 will be described below.

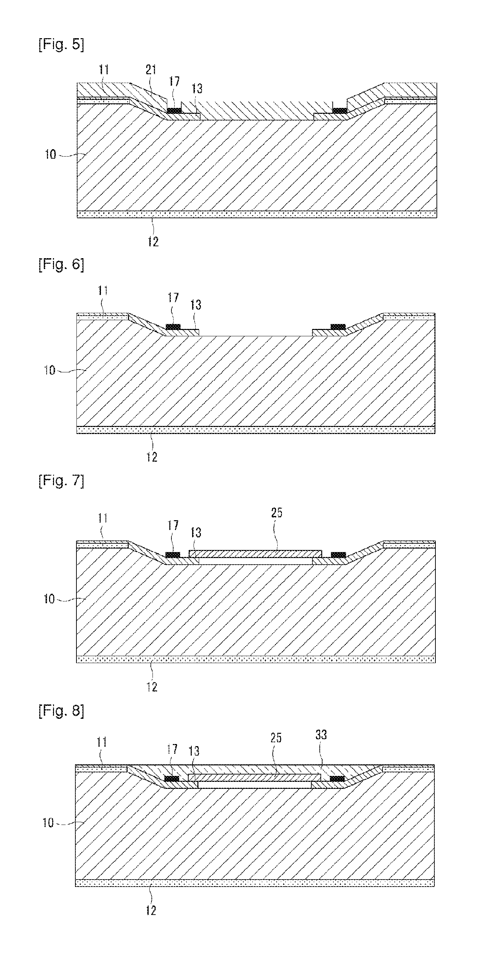

A photosensitive masking material 21 is applied on a surface of the silicon substrate 10, in which the silicon substrate 10 is formed. A region in which the contact-preventing electrode unit 17 is to be formed is patterned by exposing and developing the photosensitive masking material 21. The contact-preventing electrode unit 17 is deposited to the patterned region (refer to FIG. 5). Next, the photosensitive masking material 21 is removed (refer to FIG. 6).

Here, the membrane 25 and the back plate 37 have polarities opposite to each other, whereas the contact-preventing electrode unit 17 has the same polarity as the back plate 37. A contact-preventing circuit (not shown) may be connected to the contact-preventing electrode unit 17 to control intensity of a current applied to the contact-preventing electrode unit 17. Such a contact-preventing circuit may apply a current to the contact-preventing electrode unit 17 when an excessive current is applied to the membrane 25 or an external shock is applied to the membrane 25. A detailed description of the contact-preventing electrode unit 17 will be given below.

FIG. 7 is a sectional view showing an operation for forming a membrane to an air gap forming portion.

Referring to FIG. 7, the membrane 25 is formed on the top surface of the air gap forming portion 15 of the silicon substrate 10. Here, the membrane 25 is apart from the contact-preventing electrode unit 17. The membrane 25 is a diaphragm which oscillates due to sound pressure and is a bottom electrode of a condenser for measuring a capacitance.

The membrane 25 may be formed by using an electroless plating method. The membrane 25 is electroless plated as described below.

First, the photosensitive masking material 21 is applied to a surface of the silicon substrate 10 in which the air gap forming portion 15 is formed. A region in which the membrane 25 is to be formed is patterned by exposing and developing the photosensitive masking material 21. After the membrane 25 is formed, the photosensitive masking material 21 is removed. Next, a surface of the membrane 25 is cleaned.

Since the membrane 25 is formed as conductive ions are reduced and substituted at a relatively low temperature, which is about 90°C, in an electroless plating operation, it is not necessary to heat a metal for forming membrane 25 to a high temperature, which is about 1100°C, to form the membrane 25, unlike in the related art. Furthermore, since the membrane 25 is formed of a metal, the membrane 25 may be electrically connected to an external circuit for measuring capacitance (e.g., an application specific integrated chip (ASIC)). Therefore, unlike in the related art, it is not necessary to perform a separate high-temperature heating operation to implant metal ions into poly-silicon, and thus, a number of manufacturing operations may be reduced.

Furthermore, even if the membrane 25 and the silicon substrate 10 have different thermal expansion coefficients, the membrane 25 and the silicon substrate 10 are not heated to a high temperature, and thus, a small compressive stress or tensile stress, which is residual stress, is formed in an area where the membrane 25 and the silicon substrate 10 contact each other. As a result, since the membrane 25 is barely deformed by residual stress, the membrane 25 may normally oscillate, and thus, the acoustic properties may be stabilized.

Meanwhile, the membrane 25 may be formed of a soft conductive material containing nickel. Since the membrane 25 is formed of a conductive material, an electric current may flow through the membrane 25. Furthermore, since the membrane 25 is formed of a soft material, the membrane 25 may be prevented from being damaged when the membrane 25 oscillates due to an excessive voltage or when an external shock is applied to the membrane 25.

Furthermore, the membrane 25 may be formed to have a thickness from about 0.1 µm to about 5 µm. The thickness of the membrane 25 may be suitably adjusted according to a sound pressure detected by the MEMS microphone.

Meanwhile, when the membrane 25 is electroless plated, a metal vapor for plating may be sprayed in an almost vertical direction or a slightly tilted direction from the upper portion of the air gap forming portion 15 to the lower portion of the air gap forming portion 15 by a sputter or an electron beam (E-beam), so that the membrane 25 and electrodes (not shown) may be easily connected to each other without being short-circuited on the slopes surface 16 of the air gap forming portion 15.

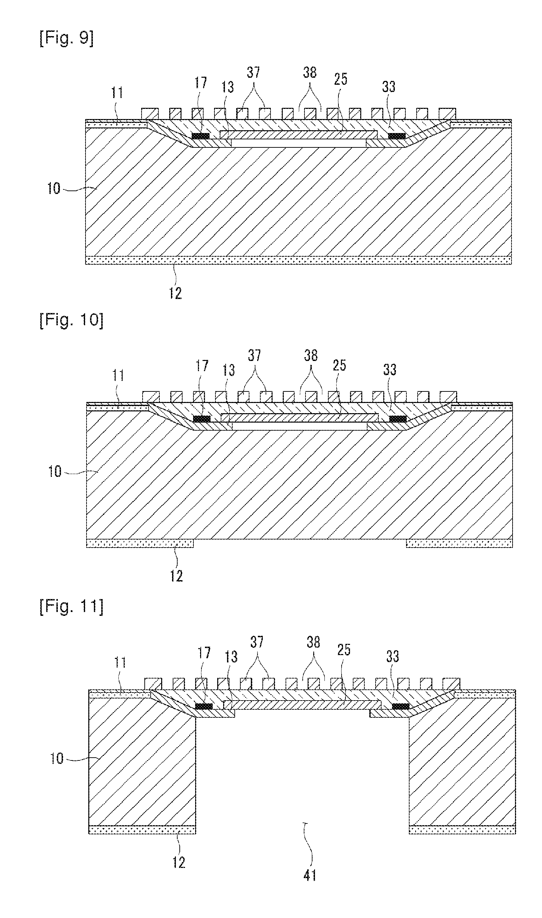

FIGS. 8 and 9 are sectional views showing operations for forming a sacrificing layer and a back plate to the top surface of a membrane of a silicon substrate.

Referring to FIG. 8, a sacrificing layer 33 is formed on the air gap forming portion 15. Here, the sacrificing layer 33 is deposited to the air gap forming portion 15, which is formed by etching a portion of the silicon substrate 10 to a predetermined depth, and thus, it is not necessary to form or etch a separate layer to form the sacrificing layer 33. Therefore, the sacrificing layer 33 may be easily formed, and a number of operations may be reduced.

The sacrificing layer 33 may be formed such that the top surface of the sacrificing layer 33 and the top surface of the silicon substrate 10 form an even surface. Here, if the sacrificing layer 33 is formed of a material with relatively high viscosity, the surface of the sacrificing layer 33 may be planarized by performing chemical mechanical polishing (CMP) thereon. On the contrary, if the sacrificing layer 33 is formed of a material with relatively low viscosity, the sacrificing layer 33 may have a flat surface, and thus, it may not be necessary to perform the CMP

The sacrificing layer 33 may be formed of a material such as silicon oxide, photoresist, plated copper, etc.

Referring to FIG. 9, the back plate 37 may be electroless plated onto the top surface of the sacrificing layer 33. The back plate 37 may be formed to have a thickness from about 2 µm to about 100 µm. The back plate 37 is arranged to face the membrane 25 and is a top electrode of a condenser for measuring a capacitance of the membrane 25.

The back plate 37 is electroless plated as described below.

First, a photosensitive masking material (not shown) is applied to a surface of the sacrificing layer 33. A region in which the back plate 37 is to be formed is patterned by exposing and developing the photosensitive masking material. Here, the region in which the back plate 37 is to be formed has a shape in which a plurality of sound holes 38 may be formed. The patterned region in which the back plate 37 is to be formed is surface-activated to be electroless plated. The nickel back plate 37 is electroless plated to the surface-activated patterned region in which the back plate 37 is to be formed. After the nickel back plate 37 is formed, the photosensitive masking material is removed, and thus, the back plate 37 is formed. Next, a surface of the back plate 37 is cleaned.

Since the back plate 37 is formed as conductive ions are reduced and substituted at a relatively low temperature, which is about 90°C, in an electroless plating operation, it is not necessary to heat a metal for forming the back plate to a high temperature, which is about 1100°C, to form the back plate 37, unlike in the related art. Furthermore, since the back plate 37 is formed of a metal, the back plate 37 may be electrically connected to an external circuit for measuring capacitance (e.g., an ASIC). Therefore, unlike in the related art, it is not necessary to perform a separate high-temperature heating operation to implant metal ions to poly-silicon, and thus a number of manufacturing operations may be reduced.

Furthermore, even if the back plate 37 and the silicon substrate 10 have different thermal expansion coefficients, the back plate 37 and the silicon substrate 10 are not heated to a high temperature, and thus, a small compressive stress or tensile stress, which is residual stress, is formed in an area where the back plate 37 and the silicon substrate 10 contact each other. As a result, since the back plate 37 is barely deformed by residual stress, formation of cracks in the area where the back plate 37 and the silicon substrate 10 contact each other may be prevented.

The back plate 37 may be formed of a soft conductive material containing nickel. Since the back plate 37 is formed of a conductive material, an electric current may flow through the back plate 37. Furthermore, since the back plate 37 is formed of a soft material, the back plate 37 may be prevented from being damaged when an external shock is applied thereto.

FIGS. 10 through 12 are sectional views showing operations for forming a back chamber and an air gap in a silicon substrate.

Referring to FIGS. 10 and 11, a photosensitive masking material (not shown) is applied to the insulation protection layer 12 on the bottom surface of the silicon substrate 10. A region in which a back chamber 41 is to be formed is patterned by exposing and developing the photosensitive masking material.

The region in which the back chamber 41 is to be formed may be anisotropically wet-etched by using the KOH solution or the TMAH solution (refer to FIG. 10). Here, the masking material may be silicon nitride, silicon dioxide, gold, or chrome.

Furthermore, the region in which the back chamber 41 is to be formed may be anisotropically dry-etched by using a deep reactive icon etching (DRIE) method (refer to FIG. 10). Here, the masking material may be silicon nitride, silicon dioxide, gold, or chrome.

As described above, as the lower portion of the silicon substrate 10 is etched, the back chamber 41 is formed below the membrane 25. Here, the insulation layer 13 protrudes toward back chamber 41 by a predetermined length, and two opposite ends of the membrane 25 and the contact-preventing electrode unit 17 are arranged on the protruding portion of the insulation layer 13. Since the protruded portion of the insulation layer 13 is elastic, the membrane 25 may easily oscillate.

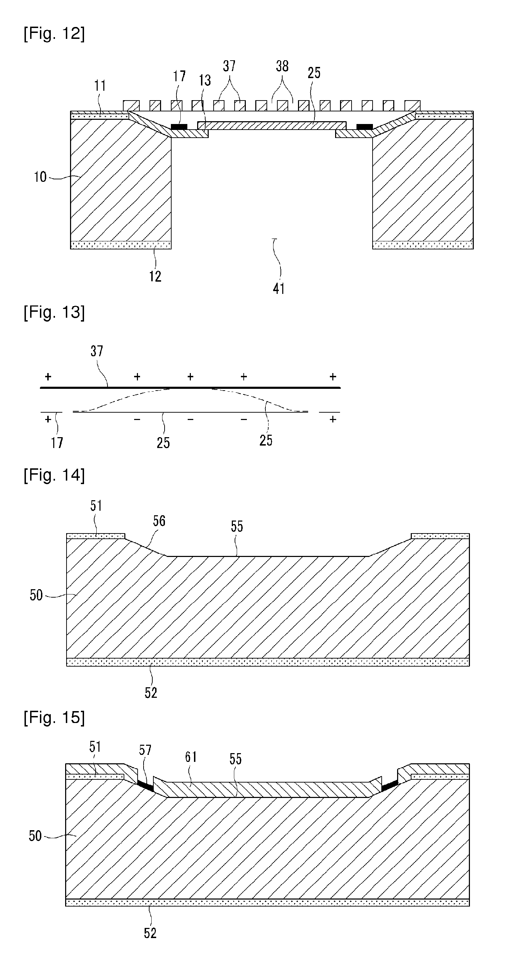

Referring to FIG. 12, the sacrificing layer 33 is removed by etching it via the sound holes 38 of the back plate 37. Here, as the sacrificing layer 33 is removed, an air gap 45 is formed between the membrane 25 and the back plate 37. The air gap 45 allows the membrane 25 to oscillate without contacting the back plate 37 when a sound pressure is applied to the membrane 25.

The width of the air gap 45 may be designed in advance according to a depth to which the air gap forming portion 15 is etched and a height to which the sacrificing layer 33 is formed. Therefore, the membrane 25 and the back plate 37 may be arranged inside or on a surface of the silicon substrate 10 instead of above the silicon substrate 10. As a result, according to an embodiment of the present invention, the height of the MEMS microphone may be reduced as much as the heights of the back plate 37 and the membrane 25, in comparison to that of the related art.

FIG. 13 is a diagram showing polarities of a membrane, a back plate, and a contact-preventing electrode.

Referring to FIG. 13, the membrane 25 and the back plate 37 have polarities opposite to each other, whereas the contact-preventing electrode unit 17 has the same polarity as the back plate 37.

In other words, the membrane 25 may have a negative polarity -, the back plate 37 may have a positive polarity +, and the contact-preventing electrode unit 17 may have a positive polarity +. Alternatively, the membrane 25 may have a positive polarity +, the back plate 37 may have a negative polarity -, and the contact-preventing electrode unit 17 may have negative polarity -.

Here, since the two opposite ends of the membrane 25 and the contact-preventing electrode unit 17 are arranged on the protruding portion of the insulation layer 13, the membrane 25 is pushed downward by a repulsive force between the contact-preventing electrode unit 17 and the back plate 37. Therefore, the membrane 25 and the contact-preventing electrode unit 17 may be prevented from contacting each other due to an excessive voltage or an external shock. Furthermore, as it becomes easy to measure a sound pressure, the acoustic properties of the MEMS microphone may be improved.

In the MEMS microphone configured as described above, when the membrane 25 oscillates due to a sound pressure, the width of the air gap 45 between the membrane 25 and the back plate 37 changes. Here, as the width of the air gap 45 changes, a capacitance changes, and sounds are converted to electric signals via the changed capacitance.

In FIG. 13, the broken line indicates that the membrane 25 and the contact-preventing electrode unit 17 contact each other when the contact-preventing electrode unit 17 is not installed.

Next, a detailed description of an MEMS microphone according to another embodiment of the present invention will be given below.

FIG. 14 is a sectional view showing an operation for forming an air gap forming portion in a silicon substrate according to an embodiment of the present invention.

Referring to FIG. 14, the MEMS microphone includes a silicon substrate 50. Insulation protection layers 51 and 52, formed of silicon nitride (Si₃N₄) or silicon oxide (SiO₂), for example, are formed on both surfaces of the silicon substrate 50. Here, in case of the silicon nitride, the insulation protection layers 51 and 52 are formed on surfaces of the silicon substrate 50 by using low pressure chemical vapor deposition (LPCVD).

The insulation protection layer 51 on the top surface of the silicon substrate 50 is etched to form an air gap forming portion 55. Here, the insulation protection layer 51 on the top surface of the silicon substrate 50 is etched by using a reactive ion etching (RIE) equipment.

The air gap forming portion 55 is formed to a preset depth by etching the upper portion of the silicon substrate 50 by using a KOH solution or a TMAH solution.

A distance between a membrane 77 and a back plate 65 described below may be adjusted by adjusting the depth of the air gap forming portion 55 to a preset depth. The depth of the air gap forming portion 55 may be adjusted according to concentration of the KOH solution or the TMAH solution, etching time, etching temperature, etc.

Furthermore, portions surrounding the air gap forming portion 55 may form a sloped surface 56 having an angle α, which is approximately 54.74°, as the portions are etched by using the KOH solution or the TMAH solution. Here, reaction with the KOH solution or the TMAH solution is relatively slow in a direction in which silicon crystals are inclined (i.e., a direction of a surface 111), whereas reaction with the KOH solution or the TMAH solution is relatively fast in a direction perpendicular to the silicon crystals (i.e., a direction of a surface 100). Therefore, the portions surrounding the air gap forming portion 55 is etched to form the sloped surface 56.

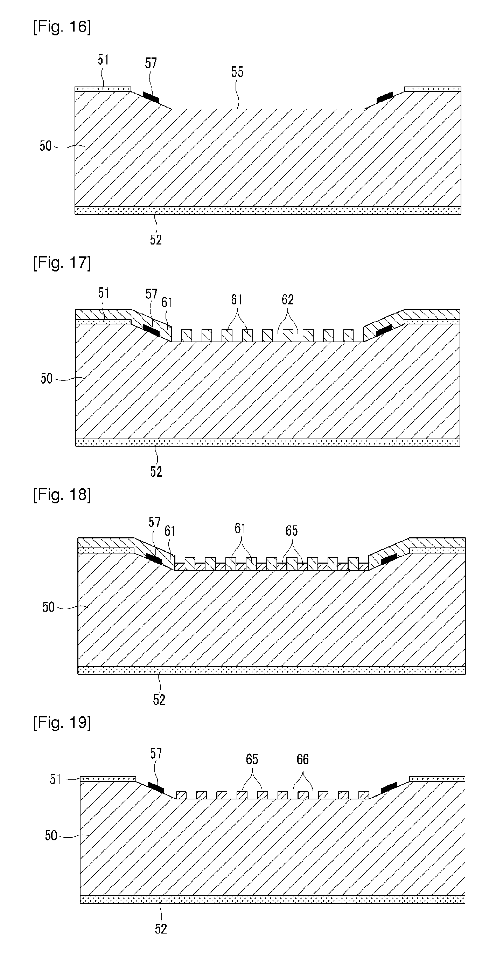

FIGS. 15 and 16 are sectional views showing operations for forming a contact-preventing electrode unit to an air gap forming portion of a silicon substrate.

Referring to FIGS. 15 and 16, a contact-preventing electrode unit 57 may be formed on the air gap forming portion 55 of the silicon substrate 50. An operation for forming the contact-preventing electrode unit 57 will be described below.

A photosensitive masking material 61 is applied on a surface of the silicon substrate 50, in which the silicon substrate 55 is formed. A region in which the contact-preventing electrode unit 57 is to be formed is patterned by exposing and developing the photosensitive masking material 61. The contact-preventing electrode unit 57 is deposited to the patterned region (refer to FIG. 15). Next, the photosensitive masking material 61 is removed (refer to FIG. 16).

Here, the membrane 77 and the back plate 65 have the same polarity, whereas the contact-preventing electrode unit 17 has a polarity opposite to that of the membrane 77. Detailed description of the contact-preventing electrode unit 57 will be given below.

FIGS. 17 through 19 are sectional views showing operations for forming a back plate to an air gap forming portion of a silicon substrate.

Referring to FIGS. 17 through 19, the back plate 65 is formed on the air gap forming portion 55 of the silicon substrate 50. Here, the back plate 65 is a bottom electrode of a condenser for measuring a capacitance.

The back plate 65 may be formed by using an electroless plating method. The back plate 65 is electroless plated as described below.

First, the photosensitive masking material 61 is applied to a surface of the silicon substrate 50 in which the air gap forming portion 55 is formed. A region in which the back plate 65 and sound holes 66 are to be formed is patterned by exposing and developing the photosensitive masking material 61 (refer to FIG. 17). The patterned region in which the back plate 65 and the sound holes 66 are to be formed is surface-activated to be electroless plated. The nickel back plate 65 is electroless plated to the surface-activated patterned region in which the back plate 65 and the sound holes 66 are to be formed (refer to FIG. 18). After the nickel back plate 65 is formed, the photosensitive masking material is removed (refer to FIG. 19). Next, a surface of the back plate 65 is cleaned.

Since the back plate 65 is formed as conductive ions are reduced and substituted at a relatively low temperature, which is about 90°C, in an electroless plating operation, it is not necessary to heat a material for forming the back plate 65 to a high temperature, which is about 1100°C, to form the back plate 65, unlike in the related art. Furthermore, since the back plate 65 is formed of a metal, the back plate 65 may be electrically connected to an external circuit for measuring capacitance (e.g., an ASIC). Therefore, unlike in the related art, it is not necessary to perform a separate high-temperature heating operation to implant metal ions to poly-silicon, and thus a number of manufacturing operations may be reduced.

Furthermore, since the back plate 65 is formed as conductive ions are reduced and substituted via electroless plating, it is not necessary to heat the material for forming the back plate 65 to a high temperature to form the back plate 65, unlike in the related art. Therefore, even if the back plate 65 and the silicon substrate 50 have different thermal expansion coefficients, the back plate 65 and the silicon substrate 50 are not heated to a high temperature, and thus, a small compressive stress or tensile stress, which is residual stress, is formed in an area where the back plate 65 and the silicon substrate 50 contact each other. As a result, since the back plate 65 is barely deformed by residual stress, the back plate 65 may normally oscillate, and thus, acoustic properties may be stabilized.

The back plate 65 may be formed of a soft conductive material containing nickel. Since the back plate 65 is formed of a conductive material, an electric current may flow through the back plate 65. Furthermore, since the back plate 65 is formed of a soft material, the back plate 65 may be prevented from being damaged when an external shock is applied thereto.

Furthermore, the back plate 65 may be formed to have a thickness from about 2 µm to about 10 µm.

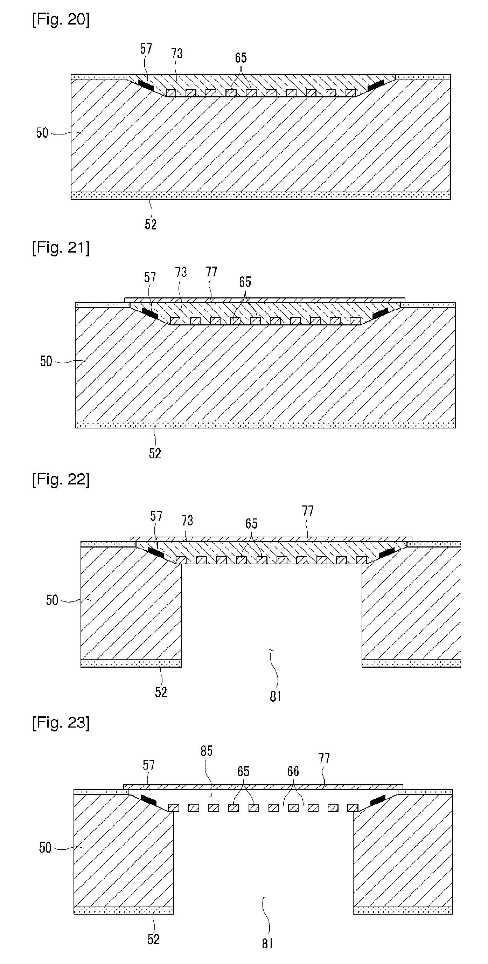

FIGS. 20 and 21 are sectional views showing operations for forming a sacrificing layer and a back plate to the top surface of a membrane of a silicon substrate.

Referring to FIG. 20, a sacrificing layer 73 is formed on the air gap forming portion 55 (refer to FIG. 20). Here, the sacrificing layer 73 may be formed, such that the top surface of the sacrificing layer 73 and the top surface of the silicon substrate 50 form an even surface. Here, if the sacrificing layer 73 is formed of a solid material with relatively high viscosity, the surface of the sacrificing layer 73 may be planarized by performing chemical mechanical polishing (CMP) thereon. On the contrary, if the sacrificing layer 73 is formed of a material with relatively low viscosity, the sacrificing layer 73 may have a flat surface, and thus, it may not be necessary to perform the CMP

The sacrificing layer 73 may be formed of a material such as silicon oxide, photoresist, plated copper, etc.

Referring to FIG. 21, the membrane 77 may be electroless plated to the top surface of the sacrificing layer 73. The membrane 77 may be formed to have a thickness from about 0.2 µm to about 2 µm. The membrane 77 is a diaphragm that oscillates due to sound pressure and is a top electrode of a condenser for measuring a capacitance.

The membrane 77 is electroless plated as described below.

First, a photosensitive masking material (not shown) is applied to a surface of the sacrificing layer 73. A region in which the membrane 77 is to be formed is patterned by exposing and developing the photosensitive masking material. The patterned region in which the membrane 77 is to be formed is surface-activated to be electroless plated. The nickel membrane 77 is electroless plated to the surface-activated patterned region in which the membrane 77 is to be formed. After the nickel membrane 77 is formed, the photosensitive masking material is removed. Next, a surface of the membrane 77 is cleaned.

Furthermore, since the membrane 77 is formed as conductive ions are reduced and substituted at a relatively low temperature, which is about 90°C, in an electroless plating operation, it is not necessary to heat a material for forming the membrane 77 to a high temperature, which is about 1100°C, to form the membrane 77, unlike in the related art.

Furthermore, even if the membrane 77 and the silicon substrate 50 have different thermal expansion coefficients, the membrane 77 and the silicon substrate 50 are not heated to a high temperature, and thus, a small compressive stress or tensile stress, which is residual stress, is formed in an area where the membrane 77 and the silicon substrate 50 contact each other. As a result, since the membrane 77 is barely deformed by residual stress, formation of cracks in an area where the membrane 77 and the silicon substrate 50 contact each other may be prevented.

FIGS. 22 and 23 are sectional views showing operations for forming a back chamber and an air gap in a silicon substrate.

Referring to FIGS. 22 and 23, a photosensitive masking material (not shown) is applied to the insulation protection layer 52 on the bottom surface of the silicon substrate 50. A region in which a back chamber 81 is to be formed is patterned by exposing and developing the photosensitive masking material.

The region in which the back chamber 81 is to be formed may be anisotropically wet-etched by using the KOH solution or the TMAH solution. Here, the masking material may be silicon nitride, silicon dioxide, gold, or chrome.

Furthermore, the region in which the back chamber 81 is to be formed may be anisotropically dry-etched by using a deep reactive icon etching (DRIE) method. Here, the masking material may be silicon nitride, silicon dioxide, gold, or chrome.

As described above, as the lower portion of the silicon substrate 50 is etched, the back chamber 81 is formed below the back plate 65.

Referring to FIG. 23, the sacrificing layer 73 is removed by etching it via the sound holes 66 of the back plate 65. Here, as the sacrificing layer 73 is removed, an air gap 85 is formed between the membrane 77 and the back plate 65. The air gap 85 allows the membrane 77 to oscillate without contacting the back plate 65 when sound pressure is applied to the membrane 77.

The width of the air gap 85 may be designed in advance according to a depth to which the air gap forming portion 55 is etched and a height to which the sacrificing layer 73 is formed. Therefore, the membrane 77 and the back plate 65 may be arranged inside or on a surface of the silicon substrate 50 instead of above the silicon substrate 50. As a result, according to an embodiment of the present invention, the height of an MEMS microphone may be reduced as much as the heights of the back plate 65 and the membrane 77, in comparison to that of the related art.

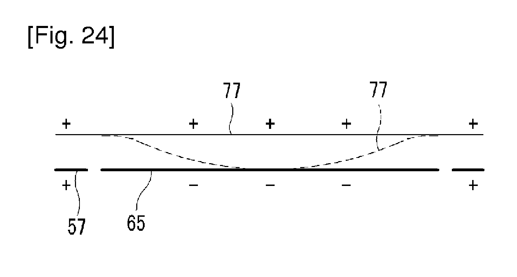

FIG. 24 is a diagram showing polarities of a membrane, a back plate, and a contact-preventing electrode.

Referring to FIG. 24, the membrane 77 and the back plate 65 have polarities opposite to each other, whereas the contact-preventing electrode unit 57 has the same polarity as the membrane 77.

In other words, the membrane 77 may have a positive polarity +, the back plate 65 may have a negative polarity -, and the contact-preventing electrode unit 57 may have a positive polarity +. Alternatively, the membrane 77 may have a negative polarity -, the back plate 65 may have a positive polarity +, and the contact-preventing electrode unit 57 may have a negative polarity -.

Here, since the contact-preventing electrode unit 57 faces the membrane 77, the back plate 65 and the membrane 77 may be prevented from contacting each other due to an excessive voltage or an external shock. Therefore, it becomes easy to measure sound pressure, and thus, acoustic properties of an MEMS microphone may be improved.

In FIG. 24, the broken line indicates the membrane 77 and the back plate 65 contact each other when the contact-preventing electrode unit 57 is not installed.

According to the above embodiments of the present invention, an air gap between a membrane and a back plate may be adjusted by adjusting a depth to which an air gap forming portion is to be etched.

Furthermore, since the membrane and the back plate are formed by using the same material containing nickel, operations for manufacturing an MEMS microphone may be simplified and costs for manufacturing an MEMS microphone may be reduced.

Furthermore, since the membrane and the back plate are formed on a silicon substrate in the same operation, operations for manufacturing an MEMS microphone may be simplified and yields of manufacturing MEMS microphones may be significantly improved.

Furthermore, since the membrane and the back plate are formed at a relatively low temperature via electroless plating, formation of residual stress in an area where the silicon substrate, the membrane, and the back plate contact each other may be minimized. Therefore, deformation of the membrane or formation of cracks in an area where the membrane and the back plate contact each other may be prevented. Furthermore, operations for manufacturing an MEMS microphone may be simplified and costs for manufacturing an MEMS microphone may be reduced.

### Industrial Applicability

According to embodiments of the present invention, a membrane and a back plate may be prevented from contacting each other even if an excessive voltage or an external shock is applied thereto, and thus sound pressure may be accurately measured.

## Claims

1. An MEMS microphone comprising:
a silicon substrate in which a back chamber is to be formed;
a back plate which is formed on the silicon substrate and has formed therein a plurality of sound holes;
a membrane which is formed on the silicon substrate at a predetermined distance apart from the back plate to form an air gap; and
a contact-preventing electrode unit which is formed on the silicon substrate and applies a repulsive force to the membrane.

2. The MEMS microphone of claim 1, wherein
the membrane and the back plate have polarities opposite to each other, and
the contact-preventing electrode unit has the same polarity as the membrane.

3. The MEMS microphone of claim 1, wherein
an air gap forming portions is formed in the silicon substrate by etching the silicon substrate to a preset depth,
the membrane is formed on the upper portion or the lower portion of the air gap forming portion;
the back plate is formed on the upper portion or the lower portion of the air gap forming portion to form an air gap by being apart from the membrane; and
the contact-preventing electrode unit is formed at the lower portion of the air gap forming portion.

4. The MEMS microphone of claim 3, wherein a distance between the membrane and the back plate is adjusted according to a depth of the air gap forming portion.

5. A method of manufacturing a MEMS microphone, the method comprising:
forming a contact-preventing electrode unit to a silicon substrate;
forming a membrane to the silicon substrate to be apart from the contact-preventing electrode unit;
forming a sacrificing layer to the membrane;
forming a back plate for applying a repulsive force to the contact-preventing electrode unit onto the sacrificing layer;
forming a back chamber by etching the lower portion of the silicon substrate; and
forming an air gap between the membrane and the back chamber by removing the sacrificing layer.

6. The method of claim 5, wherein the step of forming a contact-preventing electrode unit comprises:
forming an air gap forming portion in the silicon substrate; and
forming the contact-preventing electrode unit on the bottom of the air gap forming portion.

7. The method of claim 6, wherein a distance between the membrane and the back plate is adjusted according to a depth of the air gap forming portion.

8. A method of manufacturing an MEMS microphone, the method comprising:
forming a contact-preventing electrode unit to a silicon substrate;
forming a back plate to the silicon substrate to be apart from the contact-preventing electrode unit;
forming a sacrificing layer to the back plate;
forming a membrane for applying repulsive force to the contact-preventing electrode unit onto the sacrificing layer;
forming a back chamber by etching the lower portion of the silicon substrate; and
forming an air gap between the membrane and the back chamber by removing the sacrificing layer.

9. The method of claim 8, wherein the step of forming a contact-preventing electrode unit comprises:
forming an air gap forming portion in the silicon substrate; and
forming the contact-preventing electrode unit on the bottom of the air gap forming portion.

10. The method of claim 9, wherein a distance between the membrane and the back plate is adjusted according to a depth of the air gap forming portion.
